# DEMANDE DE BREVET EUROPEEN

(11) **EP 4 730 957 A1**
(43) Date de publication de la demande: **22.04.2026**
(21) Numéro de dépôt: 25208810.9
(22) Date de dépôt: 15.10.2025
(51) Int. Cl.: H10D 48/01, H10D 48/00, H10D 62/10, H10D 64/27, B82Y 10/00

(54) **DISPOSITIF QUANTIQUE COMPRENANT UNE RÉGION ACTIVE À NANOFEUILLE ET DES BOÎTES QUANTIQUES INDUITS DANS SES CÔTÉS LATÉRAUX OPPOSÉS ET PROCÉDÉ POUR SA FABRICATION**

(30) Priorité: 16.10.2024 FR 2411185
(71) Demandeur: Commissariat à l'Energie Atomique et aux Energies Alternatives, 75015 Paris (FR)
(72) Inventeur: LABRACHERIE, Valentin, 38054 GRENOBLE Cedex 09 (FR); BERTRAND, Benoit, 38054 GRENOBLE Cedex 09 (FR); NIEBOJEWSKI, Heimanu, 38054 GRENOBLE Cedex 09 (FR)
(74) Mandataire: Hautier IP

(57) **Abrégé**

L'invention porte sur un dispositif quantique comprenant une zone active (12A) s'étendant selon une direction longitudinale (y), et des grilles QD (G11, G12) s'étendant selon une direction transverse (x) lesdites grilles QD (G11, G12) étant disposées de part et d'autre de la zone active (12A), en vis-à-vis, pour contrôler un point quantique (QD1, QD2). Le dispositif comprend plusieurs grilles transverses (GT) chacune disposée sur une paire de grilles QD (G11, G12) en vis-à-vis, et séparée desdites grilles QD (G11, G12) et de la zone active (12A) par un diélectrique de grille (21). Chaque grille transverse (GTA) est configurée pour contrôler une barrière tunnel transverse entre les points quantiques (QD1, QD2).

## Description

### DOMAINE TECHNIQUE

La présente invention concerne le domaine de la microélectronique et de l'électronique quantique en particulier. Elle trouve par exemple pour application particulièrement avantageuse la réalisation de dispositifs quantiques à bits quantiques (appelés quantum bits ou qubits), notamment des dispositifs à qubits de spin.

### ETAT DE LA TECHNIQUE

Un dispositif quantique à qubits de spin comprend typiquement une zone active, par exemple sous forme de nanofil ou nanoruban, où sont formés les points quantiques, et des grilles de contrôle associées aux points quantiques. Les grilles de contrôle permettent typiquement de confiner les charges élémentaires au niveau des points quantiques, en formant un puit de potentiel électrostatique dans la zone active.

Les dispositifs quantiques à qubits de spin sont généralement basés sur une architecture en réseau bilinéaire de points quantiques. Une telle architecture permet à la fois le contrôle et la détection d'état de ces points quantiques.

Une première ligne du réseau de points quantiques peut être dédiée à la définition des qubits proprement dits, tandis que la deuxième ligne du réseau peut être mise à profit pour former des boites quantiques servant à la lecture des qubits. Des sous-réseaux de quelques qubits peuvent également être formés via cette architecture de réseau bilinéaire.

Pour assurer un confinement fiable au niveau de chaque point quantique, des grilles de contrôle du couplage par effet tunnel entre points quantiques peuvent être intercalées. Des grilles dites longitudinales peuvent être intercalées entre les points quantiques d'une même ligne, pour contrôler les barrières tunnel entre points quantiques selon la direction longitudinale, c'est-à-dire le long de la ligne de points quantiques.

Le document FR3120740A1 divulgue en outre une grille « transverse », permettant de contrôler les barrières tunnel entre les points quantiques en vis-à-vis des deux lignes du réseau bilinéaire, selon la direction transverse, c'est-à-dire perpendiculairement aux lignes de points quantiques. Cette grille transverse s'étend longitudinalement au-dessus de la zone active et permet de découpler les première et deuxième lignes de points quantiques. Ce découplage transverse n'est pas optimal. Cela peut s'avérer problématique pour le contrôle des qubits ou pour la compensation du désordre local.

Il existe donc un besoin pour de nouvelles architectures de dispositifs quantiques permettant un contrôle amélioré des qubits, et une meilleure gestion du couplage par effet tunnel.

Un objectif de l'invention est de répondre à ce besoin, et de pallier au moins en partie les inconvénients des solutions connues.

En particulier, un objet de l'invention est un dispositif quantique permettant un contrôle de l'effet tunnel transverse amélioré. Un autre objet de l'invention est un procédé de réalisation d'un tel dispositif.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un dispositif quantique comprenant successivement, en empilement selon une direction z :
- une couche de support,
- une couche isolante et
- une zone active s'étendant principalement selon une direction dite longitudinale,
- des premières grilles de contrôle dites QD, s'étendant principalement selon une direction transverse par rapport à la zone active, lesdites premières grilles QD étant disposées de part et d'autre de la zone active, en vis-à-vis, chaque première grille QD étant configurée pour contrôler un puits de potentiel dans la zone active, ledit puits de potentiel définissant un point quantique.

Avantageusement, le dispositif comprend en outre des grilles de contrôle dites transverses, s'étendant principalement selon la direction transverse, chaque grille transverse étant disposée sur deux premières grilles QD en vis-à-vis formant une paire de premières grilles QD, et séparée desdites premières grilles QD et de la zone active par un premier diélectrique de grille, chaque grille transverse étant configurée pour contrôler une barrière tunnel transverse entre les premières grilles QD de ladite paire de premières grilles QD. Chaque grille transverse est typiquement associée à une unique paire de grilles QD.

Ainsi, la barrière tunnel transverse est contrôlée localement entre deux points quantiques de chaque paire de points quantiques en vis-à-vis. Les points quantiques arrangés en ligne d'un côté de la zone active sont individuellement découplés des points quantiques arrangés en vis-à-vis de l'autre côté de la zone active. Les grilles transverses, qui s'étendent transversalement au-dessus des premières grilles QD, permettent avantageusement un contrôle local et individuel du couplage par effet tunnel entre deux points quantiques en vis-à-vis, de part et d'autre de la zone active.

Un autre aspect de l'invention concerne un procédé de réalisation d'un tel dispositif, comprenant
- Une fourniture d'un empilement comprenant, selon la direction z, une couche de support, une couche isolante et une couche semi-conductrice,
- Une formation d'un premier masque de lithographie sur la couche semi-conductrice, configuré pour définir la zone active dans la couche semi-conductrice,
- Une gravure de la couche semi-conductrice, configurée pour former la zone active, ladite gravure exposant des bords de ladite zone active,
- Une formation d'une première barrière diélectrique sur chaque bord exposé de la zone active,
- Un dépôt d'une première couche de grille de part et d'autre du premier masque de lithographie, contre la première barrière diélectrique bordant la zone active, ladite première couche de grille étant interrompue par le premier masque de lithographie et destinée à former les premières grilles QD de part et d'autre de la zone active,
- Un retrait du premier masque de lithographie,
- Un dépôt continu d'un premier matériau diélectrique sur la première couche de grille et au-dessus de la zone active, destiné à former le premier diélectrique de grille,
- Un dépôt d'une deuxième couche de grille sur le premier matériau diélectrique, ladite deuxième couche de grille étant destinée à former les grilles transverses,
- Une formation d'un deuxième masque de lithographie sur la deuxième couche de grille, configuré pour définir les grilles transverses et des paires de premières grilles QD sous les grilles transverses,
- Une gravure selon la direction z de la deuxième couche de grille, du premier matériau diélectrique, et de la première couche de grille, de façon à former les grilles transverses, le premier diélectrique de grille et les paires de premières grilles QD sous chaque grille transverse, les grilles transverses étant auto-alignées avec les paires de premières grilles QD qu'elles surmontent.

Avantageusement, ce procédé permet de réaliser les grilles transverses en auto-alignement avec les premières grilles QD. Chaque paire de premières grilles QD en vis-à-vis selon la direction transverse est surmontée par une grille transverse auto-alignée. Les dimensions en largeur des grilles transverses sont typiquement identiques aux dimensions en largeur des premières grilles QD qu'elles surmontent. Ce contrôle dimensionnel précis permet d'améliorer le contrôle électrostatique dans le dispositif quantique. Le confinement des charges et/ou le découplage des charges entre points quantiques est ainsi amélioré.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1A illustre schématiquement en coupe transverse un dispositif quantique, selon un premier mode de réalisation de la présente invention.
La figure 1B illustre schématiquement en coupe transverse un dispositif quantique, selon une variante du premier mode de réalisation de la présente invention.
La figure 2 illustre schématiquement en perspective une étape de fabrication d'un dispositif quantique, selon un mode de réalisation de la présente invention.
Les figures 3A à 7A illustrent schématiquement en coupe transverse des étapes de fabrication d'un dispositif quantique, selon le premier mode de réalisation de la présente invention.
Les figures 3B à 7B illustrent schématiquement en coupe transverse des étapes de fabrication d'un dispositif quantique, selon la variante du premier mode de réalisation de la présente invention.
Les figures 8, 9, 10 illustrent schématiquement en perspective des étapes de fabrication d'un dispositif quantique, selon un mode de réalisation de la présente invention.
Les figures 11A, 11B, 11C, 11D illustrent schématiquement en perspective des coupes du dispositif quantique illustré à la figure 10, selon un mode de réalisation de la présente invention.
Les figures 12 à 19 illustrent schématiquement en perspective des étapes de fabrication d'un dispositif quantique, selon un deuxième mode de réalisation de la présente invention.
Les figures 20A, 20B illustrent schématiquement en perspective des coupes du dispositif quantique illustré à la figure 19, selon un deuxième mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, chaque grille transverse est superposée à la paire de premières grilles QD, selon la direction z.

Selon un exemple, les premières grilles QD couvrent en partie la zone active. Cela améliore le contrôle électrostatique des QD.

Selon un exemple alternatif, les premières grilles QD ne recouvrent pas la zone active.

Selon un exemple, chaque grille transverse présente une dimension en largeur sensiblement égale aux dimensions en largeur des premières grilles QD de la paire de premières grilles QD que surmonte ladite grille transverse, les dimensions en largeur de la grille transverse et des premières grilles QD étant prises selon la direction longitudinale. Les grilles transverses sont sensiblement superposées sur au moins une partie de la longueur des premières grilles QD, selon la direction transverse. Le contrôle dimensionnel entre premières grilles QD et grilles transverses est amélioré. Cela permet un contrôle électrostatique plus précis. Les barrières tunnel transverses peuvent être contrôlées avec une plus grande précision.

Selon un exemple, le dispositif comprend en outre des deuxièmes grilles QD intercalées entre les premières grilles QD selon la direction longitudinale y, telles que deux deuxièmes grilles QD disposées en vis-à-vis de part et d'autre de la zone active forment une paire de deuxièmes grilles QD.

Selon un exemple, les deuxièmes grilles QD ne recouvrent pas la zone active.

Selon un exemple, le dispositif comprend en outre des grilles de contrôle dites longitudinales s'étendant principalement selon la direction transverse, chaque grille longitudinale étant intercalée entre une première grille transverse surmontant une première paire de premières grilles QD, et une deuxième grille transverse surmontant une deuxième paire de premières grilles QD. Chaque grille longitudinale est disposée sur une paire de deuxièmes grilles QD, et séparée desdites deuxièmes grilles QD, des grilles transverses et de la zone active par un deuxième diélectrique de grille. Chaque grille longitudinale est configurée pour contrôler une barrière tunnel longitudinale et/ou diagonale entre les premières grilles QD de la première paire de grilles QD et les premières grilles QD de la deuxième paire de grilles QD. Les premières grilles QD et les deuxièmes grilles QD sont typiquement alternées selon la direction longitudinale. Les grilles longitudinales sont disposées sur les deuxièmes paires de grilles QD, typiquement au niveau d'un « deuxième étage » de grilles. Les grilles longitudinales de ce deuxième étage contrôlent notamment les barrières tunnel diagonales entre les premières paires de grilles QD. Les deuxièmes paires de grilles QD, au niveau du « premier étage » de grilles, contrôlent notamment les barrières tunnel longitudinales entre les premières paires de grilles QD.

Selon un exemple, les grilles transverses et les grilles longitudinales sont disposées en alternance le long de la zone active, c'est à dire selon la direction longitudinale.

Selon un exemple, chaque grille longitudinale surmonte une paire de deuxièmes grilles QD en vis-à-vis et se superpose à ladite paire de deuxièmes grilles QD, selon la direction z. Selon un exemple, le nombre de premières grilles QD est égal à deux fois le nombre de grilles transverses. Selon un exemple, le nombre de paires de premières grilles QD est égal au nombre de grilles transverses. Selon un exemple, le nombre de deuxièmes grilles QD est égal à deux fois le nombre de grilles longitudinales. Selon un exemple, le nombre de paires de deuxièmes grilles QD est égal au nombre de grilles longitudinales.

Selon un exemple, chaque grille longitudinale présente une dimension en largeur sensiblement égale aux dimensions en largeur des deuxièmes grilles QD de la paire de deuxièmes grilles QD que surmonte ladite grille longitudinale, les dimensions en largeur de la grille longitudinale et des deuxièmes grilles QD étant prises selon la direction longitudinale. Le contrôle dimensionnel entre deuxièmes grilles QD et grilles longitudinales est amélioré. Cela permet un contrôle électrostatique plus précis. Les barrières tunnel longitudinales peuvent être contrôlées avec une plus grande précision. Les grilles longitudinales sont sensiblement superposées sur au moins une partie de la longueur des deuxièmes grilles QD, selon la direction transverse.

Selon un exemple, les grilles transverses présentent chacune une première dimension en largeur et les grilles longitudinales présentent chacune une deuxième dimension en largeur, lesdites première et deuxième dimensions en largeur étant prises selon la direction longitudinale, et la deuxième dimension en largeur est différente de la première dimension en largeur. Par exemple, la deuxième dimension en largeur est strictement supérieure à la première dimension en largeur, ou inversement.

Selon un exemple, les premier et deuxième diélectriques de grille présentent respectivement des première et deuxième épaisseurs prises selon la direction z, et la deuxième épaisseur est différente de la première épaisseur. Par exemple, la deuxième épaisseur est strictement supérieure à la première épaisseur, ou inversement.

Selon un exemple, chaque grille transverse présente une portion, typiquement une portion centrale, relativement plus épaisse formant saillie en direction de la zone active, de façon à ce que ladite portion soit rapprochée de la zone active.

Selon un exemple, chaque grille transverse présente une longueur inférieure à la somme des longueurs des premières grilles QD qu'elle recouvre, les longueurs étant prises selon la direction transverse x.

Selon un exemple, les grilles transverses sont plus courtes que les paires de premières grilles QD, selon la direction transverse. Les grilles transverses sont typiquement disposées en escalier sur les paires de premières grilles QD. Ainsi, une partie de chaque première grille QD formant la paire de premières grilles QD n'est pas couverte par la grille transverse. Cela permet de former un contact électrique avec les premières grilles QD par un via traversant, à l'aplomb de chaque première grille QD.

Selon un exemple, le dispositif comprend en outre au moins un réservoir de charge relié à la zone active, lesdites charges étant destinées à alimenter les points quantiques du dispositif. Selon un exemple, le dispositif comprend au moins deux réservoirs de charge, disposés de part et d'autre de la zone active.

Selon un exemple, les grilles longitudinales sont plus courtes que les paires de deuxièmes grilles QD, selon la direction transverse. Les grilles longitudinales sont typiquement disposées en escalier sur les paires de deuxièmes grilles QD. Ainsi, une partie de chaque deuxième grille QD formant la paire de deuxièmes grilles QD n'est pas couverte par la grille longitudinale. Cela permet de former un contact électrique avec les deuxièmes grilles QD par un via traversant, à l'aplomb de chaque deuxième grille QD.

Selon un exemple, les grilles longitudinales ne recouvrent pas la zone active.

Selon un exemple, le premier masque de lithographie surmonte une couche à base d'un matériau à haute constante diélectrique. Selon un exemple, le premier masque de lithographie est à base de SiN.

Selon un exemple, avant le dépôt de la première couche de grille, le premier masque de lithographie est partiellement gravé, sélectivement à la couche à base du matériau à haute constante diélectrique, de façon à exposer des parties de la couche à base du matériau à haute constante diélectrique au-dessus de la zone active, de sorte que les premières grilles QD formées à partir de la première couche de grille recouvrent en partie la zone active.

Selon un exemple, le procédé comprend en outre, après formation des grilles transverses surmontant des paires de premières grilles QD,
- Un dépôt d'une deuxième barrière diélectrique couvrant des flancs exposés des premières grilles QD et des grilles transverses,
- Un dépôt d'une troisième couche de grille de part et d'autre de la zone active, entre les premières grilles QD, ladite troisième couche de grille étant destinée à former des deuxièmes grilles QD de part et d'autre de la zone active,
- Un dépôt d'un deuxième matériau diélectrique sur la troisième couche de grille, destiné à former un deuxième diélectrique de grille,
- Un dépôt d'une quatrième couche de grille sur le deuxième matériau diélectrique, entre les grilles transverses, ladite quatrième couche de grille étant destinée à former des grilles longitudinales, chaque grille longitudinale étant disposée sur une paire de deuxièmes grilles QD en vis-à-vis, de part et d'autre de la zone active, les grilles longitudinales étant auto-alignées avec les paires de deuxièmes grilles QD qu'elles surmontent.

Avantageusement, le procédé permet de former des grilles transverses sur des paires de premières grilles QD, de façon auto-aligné, et des grilles longitudinales sur des paires de deuxièmes grilles QD, également de façon auto-aligné. Cela permet d'obtenir un excellent contrôle dimensionnel entre les différents types de grilles. Le contrôle électrostatique du dispositif quantique est amélioré.

Selon un exemple, le procédé comprend en outre, après formation des grilles transverses et/ou des grilles longitudinales :
- Une formation d'un troisième masque de lithographie comprenant des ouvertures à l'aplomb des grilles transverses et/ou des grilles longitudinales du côté d'une extrémité des premières grilles QD et/ou des deuxièmes grilles QD opposée à la zone active,
- Un retrait partiel des grilles transverses et/ou des grilles longitudinales au travers desdites ouvertures, de façon à exposer une partie des premières grilles QD et/ou des deuxièmes grilles QD.

Cela permet de former les grilles transverses et/ou les grilles longitudinales en escalier sur les premières grilles QD et/ou les deuxièmes grilles QD, respectivement. La reprise de contact électrique sur les premières grilles QD et/ou les deuxièmes grilles QD est facilitée. Typiquement, des vias traversant sont formés à l'aplomb des premières grilles QD et/ou des deuxièmes grilles QD.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques et les avantages d'un aspect de l'invention, par exemple le dispositif ou le procédé, peuvent être adaptés mutatis mutandis à l'autre aspect de l'invention.

L'invention porte d'une manière générale sur un dispositif quantique comprenant une pluralité de grilles transverses, et sur un procédé de fabrication d'un tel dispositif. La multiplicité des grilles transverses permet de contrôler localement des barrières quantiques transverses entre deux grilles QD d'une paire de grilles QD en vis-à-vis. Le contrôle du couplage par effet tunnel entre grilles QD selon la direction transverse est ainsi effectué « individuellement », et non collectivement comme c'est le cas dans les dispositifs connus. Les possibilités de contrôle du dispositif sont augmentées. De façon préférée, le dispositif comprend également une pluralité de grilles longitudinales. La multiplicité des grilles longitudinales permet de contrôler localement des barrières quantiques longitudinales entre différentes paires de grilles QD adjacentes. Le contrôle du couplage par effet tunnel entre grilles QD selon la direction longitudinale est également effectué « individuellement ». Le dispositif selon l'invention, qui présente typiquement une architecture de réseau bilinéaire de points quantiques, peut donc être contrôlé avec plus de précision et de façon améliorée.

Dans le dispositif quantique, la distribution de porteurs de charge est localisée au niveau d'un point quantique ou d'une boite quantique. Les boites quantiques sont typiquement formées par le biais d'un confinement électrostatique (via l'application d'une tension sur les grilles) et d'un confinement structurel (dans la couche mince de topSi formant la zone active, typiquement).

Les couplages et capacités parasites éventuels induits par les différentes grilles ne sont pas un problème essentiel pour le bon fonctionnement du dispositif. Un aspect à prendre en compte est la distance séparant une grille de contrôle de la portion de semiconducteur où sont formées les boîtes quantiques. Plus une grille est positionnée proche de la surface de la portion de semiconducteur, plus les défauts cristallins présents aux interfaces et dans l'oxyde de grille seront écrantés. Cela minimise l'impact des défauts cristallins chargés sur le potentiel et facilite le bon fonctionnement du dispositif. L'invention permet avantageusement de positionner les grilles de contrôle transverse au plus proche des boites quantiques.

Du point de vue du procédé de réalisation, l'invention permet également avantageusement un auto-alignement de tous les éléments entre eux. Cela permet un bon contrôle des distances séparant les différentes grilles et les différents éléments. Cela évite en outre de recourir à des étapes de lithographie supplémentaires. Il est donc avantageux de maximiser le taux de recouvrement du substrat par des grilles, avec des grilles au plus proche du substrat, tel que mis en œuvre selon la présente invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par des grilles « en vis-à-vis » des grilles alignées selon la direction transverse, au moins en partie ou totalement l'une de l'autre.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée SA:B. Une sélectivité SA:B de 10:1 signifie que la vitesse de gravure du matériau A est 10 fois supérieure à la vitesse de gravure du matériau B.

Un repère de préférence orthonormé, comprenant les axes x, y, z est représenté sur les figures annexées. Lorsqu'un seul repère est représenté sur une même planche de figures, ce repère s'applique à toutes les figures de cette planche. La direction transverse est orientée selon x. La direction longitudinale est orientée selon y.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

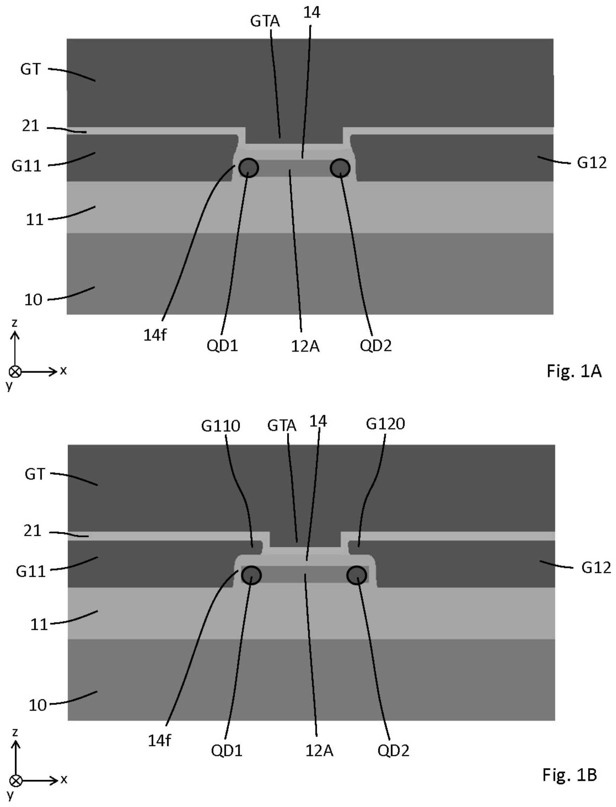

La figure 1A illustre schématiquement en coupe transverse un dispositif quantique selon un premier mode de réalisation.

Ce dispositif comprend typiquement une partie de support 10, typiquement un substrat massif de silicium dit « bulk », une couche électriquement isolante 11, typiquement une couche d'oxyde enterrée dite « BOX », et une zone active 12A, par exemple issue d'une couche de silicium dite topSi. Cet empilement peut être formé à partir d'un substrat de type SOI (silicium sur isolant).

La zone active 12A est destinée à accueillir des points quantiques QD1, QD2, typiquement en bordure de la zone active 12A. La zone active 12A présente typiquement une épaisseur de l'ordre de 5 nm à 20 nm. Cela permet de confiner structurellement les points quantiques QD1, QD2, selon z.

Le dispositif comprend en outre des grilles G11, G12 configurées pour confiner et contrôler électrostatiquement les points quantiques QD1, QD2, respectivement. Les grilles G11, G12 sont typiquement disposées en vis-à-vis l'une de l'autre selon x, de part et d'autre de la zone active 12A. Elles sont séparées de la zone active 12A par une barrière diélectrique 14f.

Le dispositif comprend en outre avantageusement une grille transverse GT recouvrant les grilles G11, G12, et la zone active 12A. La grille transverse GT est continue selon x. Elle présente typiquement une portion GTA en saillie à proximité de la zone active 12A, séparée de la zone active 12A par une couche d'oxyde 14 et par le premier diélectrique 21. Cette portion GTA se trouve typiquement au centre de la grille transverse GT selon la direction x, sensiblement à l'aplomb de la zone active 12A. Le premier diélectrique 21 sépare également la grille transverse GT des grilles G11, G12.

En polarisant la grille transverse GT, il est possible de former et de contrôler une barrière dite tunnel transverse entre les points quantiques QD1, QD2, au sein de la zone active 12A. Cela permet d'éviter qu'un couplage par effet tunnel se produise selon x, entre les points quantiques QD1, QD2.

Selon une variante illustrée à la figure 1B, les grilles G11, G12 présentent respectivement des parties G110, G120 s'étendant au-dessus de la zone active 12A, et la couvrant partiellement. Elles sont typiquement séparées de la zone active 12A par la couche d'oxyde 14. Ces parties G110, G120 permettent notamment un meilleur contrôle électrostatique des points quantiques QD1, QD2. Selon cet exemple, la grille transverse GT comprend également une partie en saillie s'approchant de la zone active 12A, entre les grilles G11, G12.

Sur les figures 1A, 1B, seules une paire de grilles G11, G12 et une grille transverse GT sont illustrées. Le dispositif comprend typiquement une pluralité de paires de grilles G11, G12 régulièrement réparties le long de la direction longitudinale y, et une pluralité de grilles transverses GT surmontant les paires de grilles G11, G12.

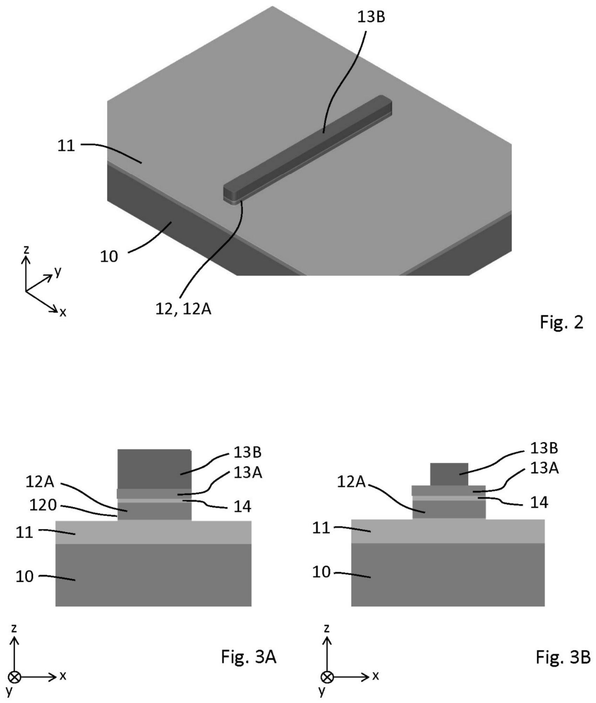

Comme illustré à la figure 2, après formation par lithographie/gravure d'un premier masque de gravure 13B définissant un motif comprenant la zone active 12A du dispositif, une gravure sèche anisotrope selon z est effectuée. La gravure est arrêtée sur la couche isolante 11 (BOX). Une gravure ionique réactive (RIE) ou une gravure plasma à base d'espèces fluorocarbonées peut être utilisée pour graver les couches sous-jacentes de l'empilement, jusqu'au BOX.

Les figures 3A, 3B illustrent deux variantes de formation du premier masque de gravure 13B, permettant de réaliser in fine les dispositifs respectivement illustrés aux figures 1A, 1B. De façon préférée, avant formation du premier masque dur 13B et avant gravure de la couche 12, une oxydation thermique est effectuée en surface de la couche 12 de façon à former la couche d'oxyde 14. Une couche 13A (optionnelle) à base d'un matériau à haute constante diélectrique est ensuite déposée. Le premier masque de gravure 13B est ensuite formé par lithographie / gravure sur l'empilement des couches 12, 14, 13A. Il peut être à base de SiN.

Selon le mode de réalisation illustré à la figure 3A, après gravure des couches 13A, 14 et 12 pour former la zone active 12A, le premier masque de gravure 13B est simplement conservé.

Selon le mode de réalisation illustré à la figure 3B, après gravure des couches 13A, 14 et 12 pour former la zone active 12A, le premier masque de gravure 13B est partiellement gravé. En particulier, le premier masque de gravure 13B à base de SiN est gravé de façon isotrope, sélectivement aux couches 12A, 13A et 14 sous-jacentes. Cela permet de réduire les dimensions selon x et selon z du premier masque de gravure 13B.

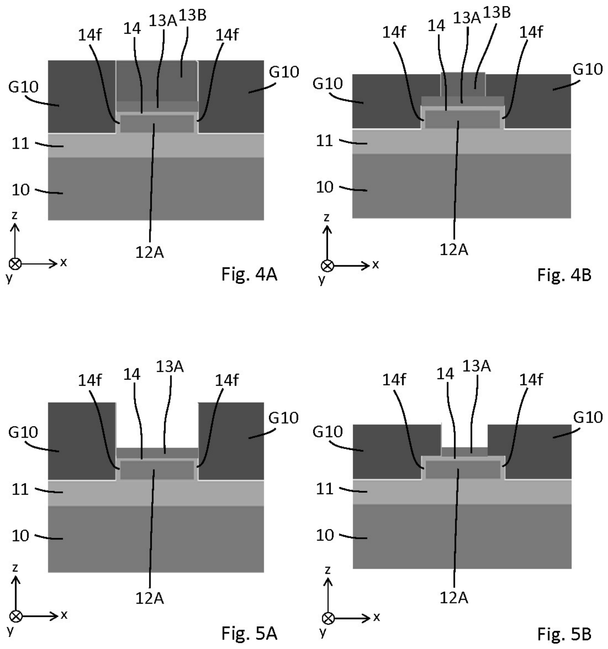

A l'issue de la gravure, les bords 120 de la zone active 12A sont exposés. Comme illustré aux figures 4A, 4B, une oxydation thermique est d'abord effectuée, de manière à former une première barrière diélectrique 14f sur chaque bord 120 exposé de la zone active 12A. Un dépôt d'une première couche de grille G10 est ensuite effectué de part et d'autre du premier masque de gravure 13B, par exemple par dépôt chimique en phase vapeur CVD. Ce dépôt est typiquement conforme et surmonte le premier masque de gravure 13B. Une étape de planarisation, typiquement par polissage mécano-chimique CMP, est alors effectuée. Cette étape de planarisation vise à retirer la première couche de grille G10 au-dessus du premier masque de gravure 13B. Le polissage CMP est configuré pour s'arrêter sur le premier masque de gravure 13B. A l'issue du dépôt et/ou de la planarisation, la première couche de grille G10 est interrompue par le premier masque de gravure 13B, selon la direction transverse x. La première couche de grille G10 est de préférence à base de silicium polycristallin.

Comme illustré aux figures 5A, 5B, après dépôt et/ou planarisation de la première couche de grille G10, le premier masque de gravure 13B est retiré sélectivement à la couche 13A et à la première couche de grille G10.

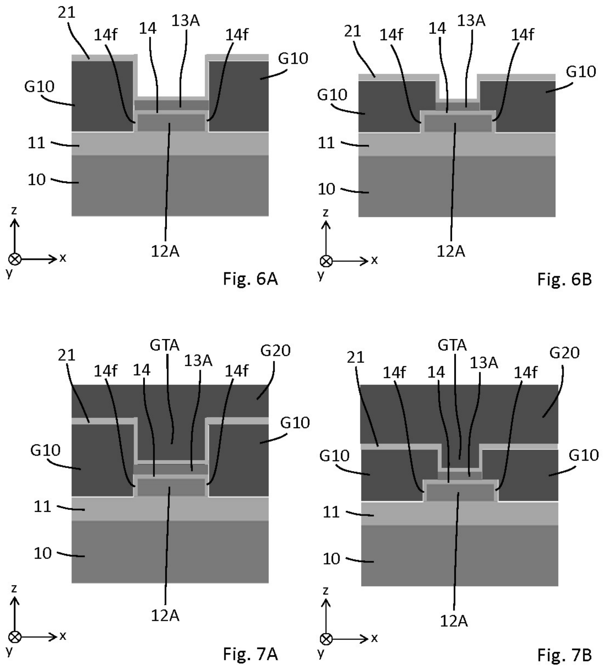

Comme illustré aux figures 6A, 6B, le premier diélectrique de grille 21 est formé par dépôt conforme d'une couche continue à base d'un premier matériau diélectrique sur la première couche de grille G10 et sur la couche 13A. Le premier diélectrique de grille 21 peut présenter une épaisseur de l'ordre de quelques nanomètres à quelques dizaines de nanomètres. Il peut être à base de SiO2.

Comme illustré aux figures 7A, 7B, un dépôt d'une deuxième couche de grille G20 est ensuite effectué sur le premier diélectrique de grille 21. La cavité située au-dessus de la zone active 12A est ainsi remplie par la deuxième couche de grille G20. Une étape de planarisation par CMP est de préférence également effectuée. La deuxième couche de grille G20 est typiquement à base de silicium polycristallin.

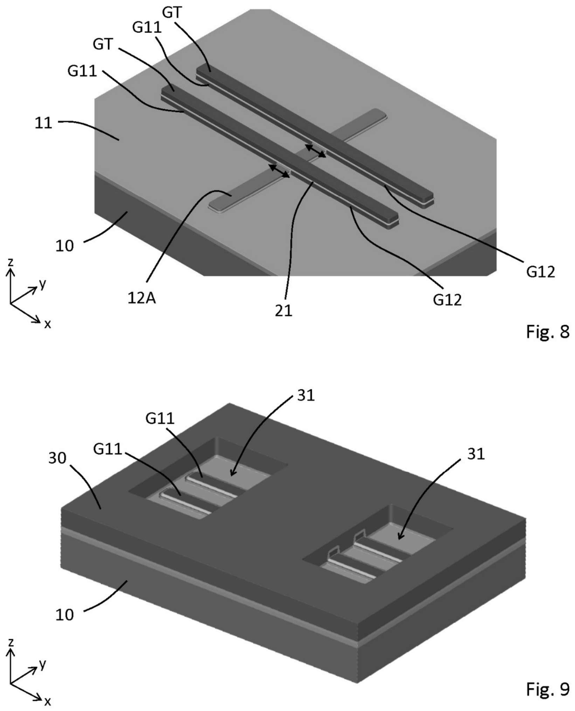

Comme illustré à la figure 8, l'empilement des couches G10, 21, G20 est ensuite structuré de façon classique par lithographie et gravure pour former les grilles G11, G12 et les grilles **GT** en superposition. La formation des grilles G11, G12 et des grilles GT se fait avantageusement par une même gravure ou série de gravures. Cela permet de limiter le nombre d'étapes de lithographie. Cela permet d'obtenir des grilles G11, G12 et des grilles GT « auto-alignées », présentant sensiblement la même largeur selon y. Le contrôle dimensionnel est optimisé. Le contrôle électrostatique via les grilles G11, G12, GT est plus précis.

Les grilles G11, G12 et les grilles GT s'étendent principalement selon la direction x, de façon transverse à la zone active 12A qui s'étend principalement selon la direction y. Les grilles GT se superposent aux grilles G11, G12 et chevauchent la zone active 12A située entre les grilles G11, G12. Le dispositif comprend avantageusement une pluralité de grilles GT permettant de contrôler localement une barrière tunnel transverse entre les grilles G11, G12 en vis-à-vis.

Selon une possibilité, des régions source et drain, ou des réservoirs pour des dispositifs quantiques, sont formés à chaque extrémité de la zone active 12A, par exemple par épitaxie de part et d'autre de la zone active selon x. Ces régions source et drain peuvent être dopées in situ lors de l'épitaxie. Elles peuvent être à base de silicium dopé phosphore Si:P par exemple. La réalisation des réservoirs et/ou des source et drain est connue de l'homme du métier.

Comme illustré à la figure 9, un masque 30 comprenant des ouvertures 31 est ensuite formé sur les grilles GT. Les ouvertures 31 sont situées de part et d'autre de la zone active 12A, au niveau des extrémités libres des grilles G11, G12. Une partie des grilles GT est ensuite gravée au travers des ouvertures 31, de façon à exposer les grilles G11, G12 sous-jacentes. Cela permet de former des grilles G11, G12 et GT en escalier. La prise de contact sur les grilles G11, G12 est ainsi facilitée.

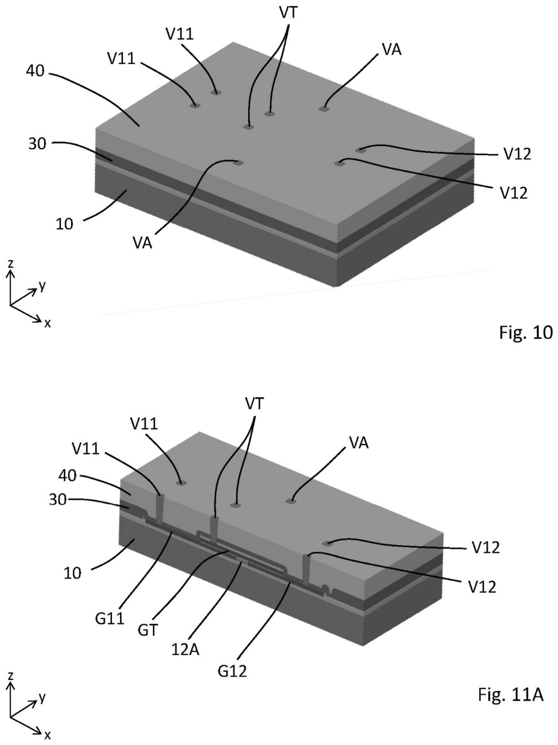

La figure 10 illustre le dispositif après encapsulation par la couche d'encapsulation 40, et formation des différents contacts électriques. Des vias V11 sont formés à l'aplomb des grilles G11, sur les parties des grilles G11 non couvertes par les grilles GT. Des vias VT sont formés à l'aplomb des grilles GT. Des vias VA sont formés à l'aplomb de la zone active 12A, à chaque extrémité selon la direction y. Des vias V12 sont formés à l'aplomb des grilles G12, sur les parties des grilles G12 non couvertes par les grilles GT.

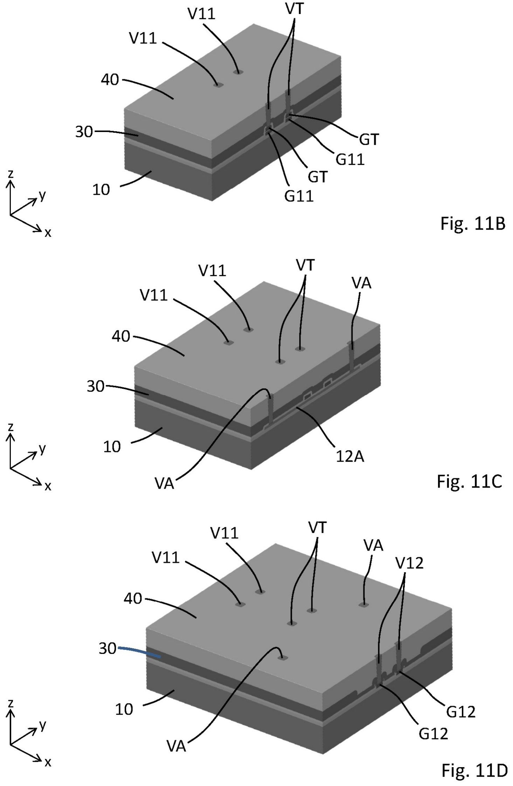

Les figures 11A-11D présentent différentes coupes transverses, selon des plans xz, et longitudinales, selon des plans zy, du dispositif illustré à la figure 10. Les grilles G11, G12 et GT en escalier, et les vias respectifs V11, V12 et VT sont visibles (figure 11A notamment). Les vias VA contactant la zone active 12A sont également visibles (figure 11C notamment).

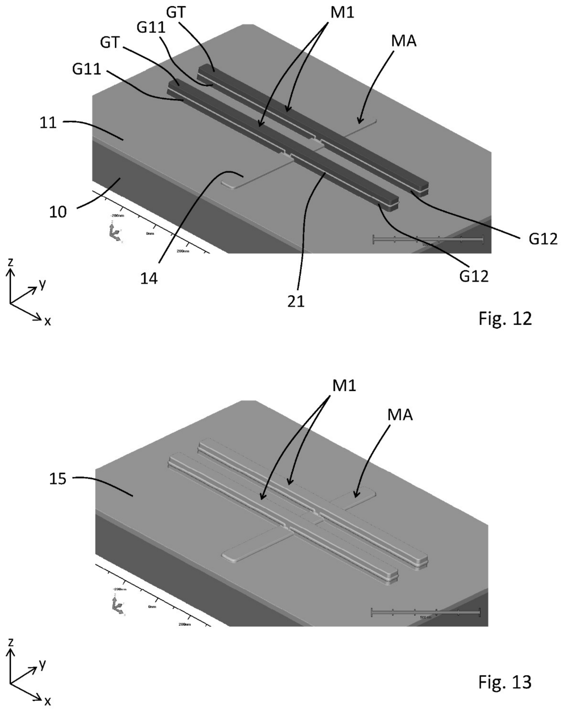

Les figures 12 à 18A illustrent différentes étapes de réalisation du dispositif, selon un deuxième mode de réalisation. Les étapes illustrées dans ces figures 12 à 18A sont typiquement effectuées après gravure et définition des grilles G11, G12 et GT, tel qu'illustré à la figure 8. Elles visent à former des grilles intercalaires entre chaque ensemble de grilles G11, G12, GT superposées, selon la direction longitudinale y. Ces grilles intercalaires supplémentaires visent en particulier à contrôler le couplage par effet tunnel entre grilles G11, et/ou entre grilles G12, et/ou entre grilles GT, selon la direction longitudinale y.

Comme illustré à la figure 12 la couche d'oxyde 14 est préservée ou reformée sur la zone active 12A. Les motifs de grilles M1 comprenant les grilles G11, G12, GT s'étendent selon x. Le motif MA comprenant la zone active 12A s'étend selon y.

Comme illustré à la figure 13, une couche d'oxyde 15 est déposée pour former une barrière diélectrique sur les parties exposées des grilles G11, G12, GT, en particulier sur les flancs des grilles G11, G12, GT et sur les sommets des grilles GT.

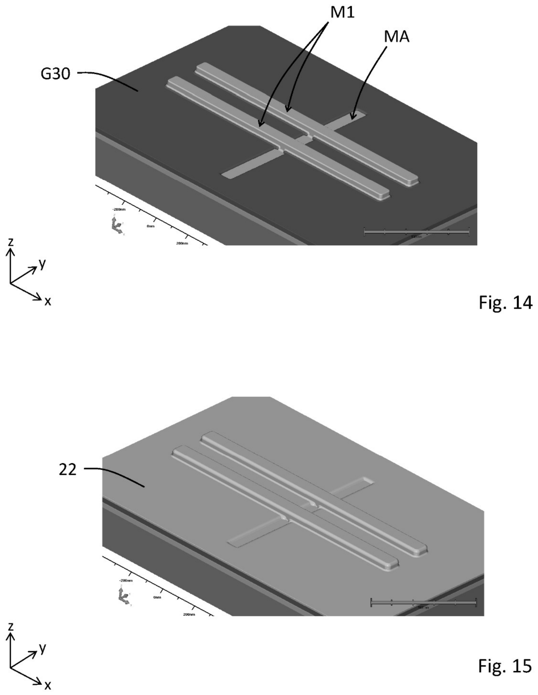

Comme illustré à la figure 14, un dépôt d'une troisième couche de grille G30 est ensuite effectué sur la couche d'oxyde 15. Afin de mettre à nu les motifs M1, MA, une étape de planarisation par CMP peut d'abord être effectuée. Une gravure partielle de la troisième couche de grille G30 peut également être effectuée. La troisième couche de grille G30 peut être à base de silicium polycristallin. De façon optionnelle, une reprise d'épitaxie peut être effectuée suite à la gravure partielle, de façon à ajuster le recouvrement des bords de la zone active 12A par la troisième couche de grille G30. A l'issue de ces étapes, la troisième couche de grille G30 est interrompue par les motifs M1, MA, qui sont en partie exposés.

Comme illustré à la figure 15, le deuxième diélectrique de grille 22 est formé par dépôt conforme d'une couche continue à base d'un deuxième matériau diélectrique sur la troisième couche de grille G30 et sur les motifs M1, MA.

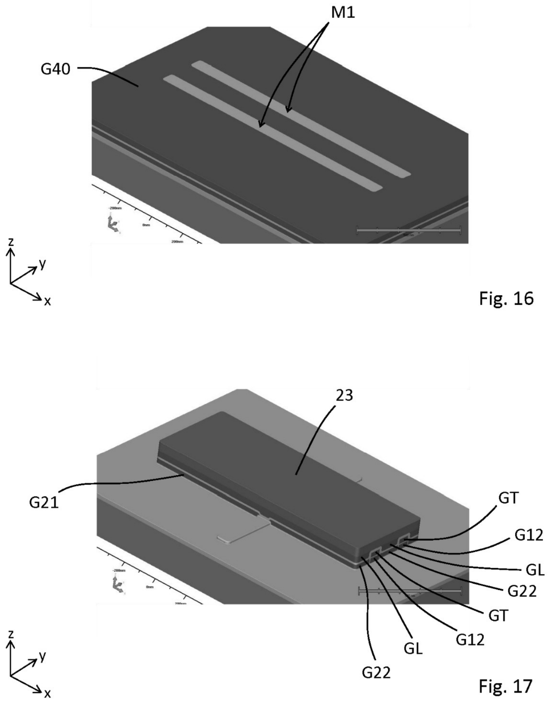

Comme illustré à la figure 16, un dépôt d'une quatrième couche de grille G40 est ensuite effectué sur le deuxième diélectrique de grille 22. La quatrième couche de grille G40 est typiquement à base de silicium polycristallin. Une étape de planarisation par CMP est de préférence effectuée afin d'exposer les sommets des motifs M1. A l'issue de ces étapes, la quatrième couche de grille G40 est interrompue par les motifs M1.

Comme illustré à la figure 17, l'empilement des couches G40, 22, G30 est ensuite structuré de façon classique par lithographie et gravure pour former les grilles G21, G22 et les grilles GL en superposition. Les grilles G21, G22, GL sont avantageusement formées entre les grilles G11, G12, GT, selon la direction y. Le pas de grilles selon y peut ainsi être divisé par deux.

La formation des grilles G21, G22 et des grilles GL se fait avantageusement par une même gravure ou série de gravures, autour du masque 23. Cela permet de limiter le nombre d'étapes de lithographie. Cela permet d'obtenir des grilles G21, G22 et des grilles GL « auto-alignées », présentant sensiblement la même largeur selon y. Le contrôle dimensionnel est optimisé. Le contrôle électrostatique via les grilles G21, G22, GL est plus précis.

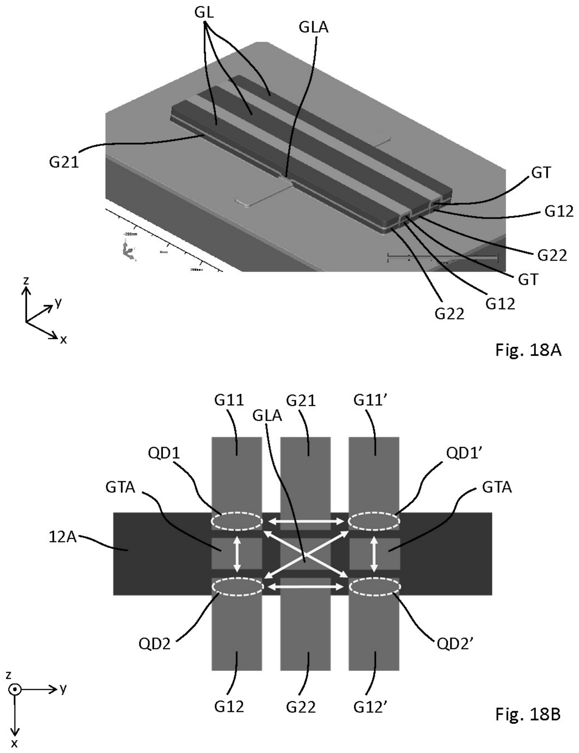

Le dispositif obtenu après retrait du masque 23 est illustré à la figure 18A. Les grilles G21, G22, GL ne présentent pas nécessairement la même largeur selon y que les grilles G11, G12, GT. Les hauteurs selon z des différentes grilles G11, G12, GT, G21, G22, GL ne sont pas nécessairement identiques. Le positionnement relatif selon z des grilles G11, G12, GT et des grilles G21, G22, GL peut varier. Les épaisseurs des premier et deuxième diélectriques de grille 21, 22 ne sont pas nécessairement identiques. Typiquement, la somme des épaisseurs des grilles ou couches G12, 21, GT, 15, 22 est égale à la somme des épaisseurs des grilles ou couches 15, G22, 22, GL.

Chaque ensemble de grilles G21, G22, GL superposées s'étend principalement selon la direction x, entre deux ensembles de grilles G11, G12, GT superposées. Le dispositif comprend avantageusement une pluralité de grilles GL permettant de contrôler localement une barrière tunnel longitudinale et/ou diagonale entre deux ensembles adjacents de grilles G11, G12, GT superposées. De façon similaire aux grilles GT, les grilles GL présentent typiquement une portion GLA en saillie à proximité de la zone active 12A, séparée de la zone active 12A par la couche d'oxyde 14 et par le deuxième diélectrique 22. Cette portion GLA se trouve typiquement au centre de chaque grille transverse GL selon la direction x, sensiblement à l'aplomb de la zone active 12A.

Comme illustré à la figure 18B, selon une possibilité de fonctionnement particulière, les portions GTA des grilles transverses GT contrôlent des barrières tunnel transverses (représentées par des flèches verticales sur la figure 18B) entre les premières grilles en vis-à-vis, ici entre les grilles G11 et G12 et entre les grilles G11' et G12'. Les deuxièmes grilles G21 et G22 contrôlent des barrières tunnel longitudinales (représentées par des flèches horizontales sur la figure 18B) entre les premières grilles côte-à-côte, ici entre les grilles G11 et G11' et entre les grilles G12 et G12'. La portion GLA de la grille longitudinale GL contrôle des barrières tunnel diagonales (représentées par des flèches diagonales sur la figure 18B) entre les premières grilles, ici entre les grilles G11 et G12' et entre les grilles G12 et G11'. Le contrôle électrostatique individuel des points quantiques QD1, QD2, QD1', QD2' est ainsi avantageusement amélioré.

A ce stade, des régions source et drain et/ou des réservoirs de charge peuvent être formés aux extrémités de la zone active. Les grilles GL et GT sont de préférence structurées en escalier, comme précédemment. Cette structuration se fait avantageusement par l'intermédiaire d'un même masque, simultanément pour les grilles GL et GT.

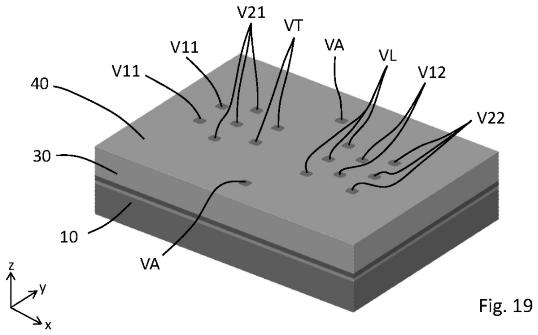

La figure 19 illustre le dispositif après encapsulation par la couche d'encapsulation 40, et formation des différents contacts électriques. Des vias V11 sont formés à l'aplomb des grilles G11, sur les parties des grilles G11 non couvertes par les grilles GT, comme précédemment. Des vias V21 sont formés à l'aplomb des grilles G21, sur les parties des grilles G21 non couvertes par les grilles GL. Des vias VT sont formés à l'aplomb des grilles GT. Des vias VA sont formés à l'aplomb de la zone active 12A, à chaque extrémité selon la direction y. Des vias VL sont formés à l'aplomb des grilles GL. Des vias V12 sont formés à l'aplomb des grilles G12, sur les parties des grilles G12 non couvertes par les grilles GT, comme précédemment. Des vias V22 sont formés à l'aplomb des grilles G22, sur les parties des grilles G22 non couvertes par les grilles GL.

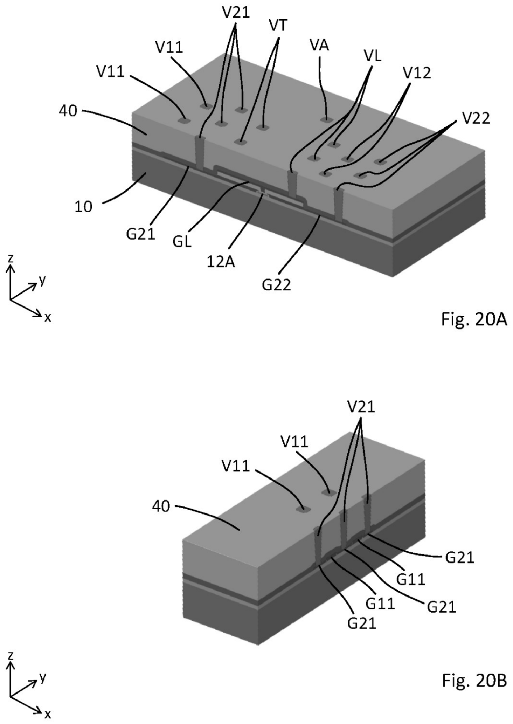

Les figures 20A, 20B présentent différentes coupes transverses, selon des plans xz, et longitudinales, selon des plans zy, du dispositif illustré à la figure 19. Les grilles G21, G22 et GL en escalier, et les vias respectifs V21, V22 et VL sont visibles (figure 20A). L'alternance des grilles G11, G21 selon y est également visible (figure 20B).

Au vu de la description qui précède, il apparaît clairement que le dispositif et le procédé proposés offrent une solution particulièrement efficace et versatile pour contrôler le couplage tunnel transverse et longitudinal pour un dispositif quantique à réseau bilinéaire. L'invention n'est pas limitée aux modes de réalisations précédemment décrits. D'autres agencements de points quantiques et/ou de barrières tunnel sont possibles, en tirant parti de la fonctionnalisation des différentes grilles décrites dans ce qui précède. Les différentes grilles ne sont pas nécessairement perpendiculaires à la zone active. Les deuxièmes grilles ne sont pas nécessairement présentes. Les grilles GL peuvent s'étendre sensiblement sur toute la hauteur des premières grilles et des grilles transverses. Les grilles GL peuvent s'étendre sur les premier et deuxième étages de grilles par exemple.

## Revendications

1. Dispositif quantique comprenant successivement, en empilement selon une direction z,
• une couche de support (10),
• une couche isolante (11) et
• une zone active (12A) s'étendant principalement selon une direction dite longitudinale (y),
le dispositif comprenant en outre :
• des premières grilles de contrôle dites QD (G11, G12), s'étendant principalement selon une direction transverse (x) par rapport à la zone active (12A), lesdites premières grilles QD (G11, G12) étant disposées de part et d'autre de la zone active (12A), en vis-à-vis, chaque première grille QD étant configurée pour contrôler un puits de potentiel dans la zone active (12A), ledit puits de potentiel définissant un point quantique (QD1, QD2),
le dispositif étant **caractérisé en ce qu'**il comprend
• une pluralité de grilles de contrôle dites transverses (GT), s'étendant chacune principalement selon la direction transverse (x), chaque grille transverse (GT) étant disposée sur deux premières grilles QD en vis-à-vis formant une paire de premières grilles QD (G11, G12), et séparée desdites premières grilles QD (G11, G12) et de la zone active (12A) par un premier diélectrique de grille (21), chaque grille transverse (GT) étant configurée pour contrôler une barrière tunnel transverse entre les points quantiques (QD1, QD2) contrôlés par ladite paire de premières grilles QD (G11, G12).

2. Dispositif selon la revendication précédente dans lequel les premières grilles QD (G11, G12) ne recouvrent pas la zone active (12A).

3. Dispositif selon l'une quelconque des revendications précédentes dans lequel chaque grille transverse (GT) présente une dimension en largeur sensiblement égale aux dimensions en largeur des premières grilles QD (G11, G12) de la paire de premières grilles QD que surmonte ladite grille transverse (GT), les dimensions en largeur de la grille transverse (GT) et des premières grilles QD (G11, G12) étant prises selon la direction longitudinale (y).

4. Dispositif selon l'une quelconque des revendications précédentes dans lequel chaque grille transverse (GT) présente une portion (GTA), typiquement une portion centrale, relativement plus épaisse formant saillie en direction de la zone active (12A), de façon à ce que ladite portion (GTA) soit rapprochée de la zone active (12A).

5. Dispositif selon l'une quelconque des revendications précédentes comprenant en outre des deuxièmes grilles QD (G21, G22) intercalées entre les premières grilles QD (G11, G12) selon la direction longitudinale (y), telles que deux deuxièmes grilles QD disposées en vis-à-vis de part et d'autre de la zone active (12A) forment une paire de deuxièmes grilles QD.

6. Dispositif selon la revendication précédente dans lequel les deuxièmes grilles QD (G21, G22) ne recouvrent pas la zone active (12A).

7. Dispositif selon l'une quelconque des deux revendications précédentes comprenant en outre des grilles de contrôle dites longitudinales (GL) s'étendant principalement selon la direction transverse (x), chaque grille longitudinale (GL) étant intercalée entre une première grille transverse (GT) surmontant une première paire de premières grilles QD (G11, G12), et une deuxième grille transverse (GT) surmontant une deuxième paire de premières grilles QD (G11, G12),
chaque grille longitudinale (GL) étant disposée au moins en partie sur une paire de deuxièmes grilles QD (G21, G22), et séparée desdites deuxièmes grilles QD (G21, G22), des grilles transverses (GT) et de la zone active (12A) par un deuxième diélectrique de grille (22),
chaque grille longitudinale (GL) étant configurée pour contrôler une barrière tunnel longitudinale et/ou diagonale entre les premières grilles QD (G11, G12) de la première paire et les premières grilles QD (G11, G12) de la deuxième paire.

8. Dispositif selon la revendication précédente dans lequel les grilles transverses (GT) et les grilles longitudinales (GL) sont disposées en alternance le long de la zone active (12A), c'est à dire selon la direction longitudinale (y).

9. Dispositif selon l'une quelconque des revendications 7 à 8 dans lequel chaque grille longitudinale (GL) présente une dimension en largeur sensiblement égale aux dimensions en largeur des deuxièmes grilles QD (G21, G22) de la paire de deuxièmes grilles QD que surmonte ladite grille longitudinale (GL), les dimensions en largeur de la grille longitudinale (GL) et des deuxièmes grilles QD (G21, G22) étant prises selon la direction longitudinale (y).

10. Dispositif selon l'une quelconque des revendications 7 à 9 dans lequel les grilles transverses (GT) présentent chacune une première dimension en largeur et les grilles longitudinales (GL) présentent chacune une deuxième dimension en largeur, lesdites première et deuxième dimensions en largeur étant prises selon la direction longitudinale (y), et dans lequel la deuxième dimension en largeur est différente de la première dimension en largeur.

11. Dispositif selon l'une quelconque des revendications 7 à 10 dans lequel les premier et deuxième diélectriques de grille (21, 22) présentent respectivement des première et deuxième épaisseurs prises selon la direction z, et dans lequel la deuxième épaisseur est différente de la première épaisseur.

12. Dispositif selon l'une quelconque des revendications précédentes comprenant en outre au moins un réservoir de charge relié à la zone active (12A), lesdites charges étant destinées à alimenter les points quantiques du dispositif.

13. Procédé de réalisation d'un dispositif quantique selon l'une quelconque des revendications précédentes, ledit procédé comprenant :
• Une fourniture d'un empilement comprenant, selon la direction z, une couche de support (10), une couche isolante (11) et une couche semi-conductrice (12),
• Une formation d'un premier masque de lithographie (13) sur la couche semi-conductrice (12), configuré pour définir la zone active (12A) dans la couche semi-conductrice (12),
• Une gravure de la couche semi-conductrice (12), configurée pour former la zone active (12A), ladite gravure exposant des bords (120) de ladite zone active (12A),
• Une formation d'une première barrière diélectrique (14f) sur chaque bord (120) exposé de la zone active (12A),
• Un dépôt d'une première couche de grille (G10) de part et d'autre du premier masque de lithographie (13B), contre la première barrière diélectrique (14f) bordant la zone active (12A), ladite première couche de grille (G10) étant interrompue par le premier masque de lithographie (13B) et destinée à former les premières grilles QD (G11, G12) de part et d'autre de la zone active (12A),
• Un retrait du premier masque de lithographie (13B),
• Un dépôt continu d'un premier matériau diélectrique sur la première couche de grille (G10) et au-dessus de la zone active (12A), destiné à former le premier diélectrique de grille (21),
• Un dépôt d'une deuxième couche de grille (G20) sur le premier matériau diélectrique, ladite deuxième couche de grille (G20) étant destinée à former les grilles transverses (GT),
• Une formation d'un deuxième masque de lithographie sur la deuxième couche de grille (G20), configuré pour définir les grilles transverses (GT) et des paires de premières grilles QD (G11, G12) sous les grilles transverses (GT),
• Une gravure selon la direction z de la deuxième couche de grille (G20), du premier matériau diélectrique, et de la première couche de grille (G10), de façon à former les grilles transverses (GT), le premier diélectrique de grille (21) et les paires de premières grilles QD (G11, G12) sous chaque grille transverse (GT), les grilles transverses (GT) étant auto-alignées avec les paires de premières grilles QD (G11, G12) qu'elles surmontent.

14. Procédé selon la revendication précédente dans lequel le premier masque de lithographie (13B) surmonte une couche (13A) à base d'un matériau à haute constante diélectrique, et dans lequel, avant le dépôt de la première couche de grille (G10), le premier masque de lithographie (13B) est partiellement gravé, sélectivement à la couche (13A) à base du matériau à haute constante diélectrique, de façon à exposer des parties de la couche (13A) à base du matériau à haute constante diélectrique au-dessus de la zone active (12A), de sorte que les premières grilles QD (G11, G12) formées à partir de la première couche de grille (G10) recouvrent en partie la zone active (12A).

15. Procédé selon l'une quelconque des revendications 13 à 14 comprenant en outre, après formation des grilles transverses (GT) surmontant des paires de premières grilles QD (G11, G12),
• Un dépôt d'une deuxième barrière diélectrique (15) couvrant des flancs exposés des premières grilles QD (G11, G12) et des grilles transverses (GT),
• Un dépôt d'une troisième couche de grille (G30) de part et d'autre de la zone active (12A), entre les premières grilles QD (G11, G12), ladite troisième couche de grille (G30) étant destinée à former des deuxièmes grilles QD (G21, G22) de part et d'autre de la zone active (12A),
• Un dépôt d'un deuxième matériau diélectrique sur la troisième couche de grille (G30), destiné à former un deuxième diélectrique de grille (22),
• Un dépôt d'une quatrième couche de grille (G40) sur le deuxième matériau diélectrique, entre les grilles transverses (GT), ladite quatrième couche de grille (G40) étant destinée à former des grilles longitudinales (GL), chaque grille longitudinale (GL) étant disposée sur une paire de deuxièmes grilles QD (G21, G22) en vis-à-vis, de part et d'autre de la zone active (12A), les grilles longitudinales (GL) étant auto-alignées avec les paires de deuxièmes grilles QD (G21, G22) qu'elles surmontent.
